# FASCICULE DE BREVET EUROPEEN

(11) **EP 0 506 557 B1**
(45) Date de publication et mention de la délivrance du brevet: **08.06.1994**
(21) Numéro de dépôt: 92400809.7
(22) Date de dépôt: 25.03.1992
(51) Int. Cl.: H01S 3/19, H01L 33/00

(54) **Procédé de réalisation d'un laser semiconducteur à ruban enterré**
Herstellungsverfahren für einen Halbleiterlaser mit vergrabener Streifenstruktur
Method of producing a buried-stripe type semiconductor laser device

(30) Priorité: 28.03.1991 FR 9103769
(43) Date de publication de la demande: 30.09.1992
(73) Titulaire: ALCATEL N.V., NL-1077 XX Amsterdam (NL)
(72) Inventeur: Lievin, Jean-Louis, F-75012 Paris (FR); Le Gouezigou, Lionel, F-91530 Le Val Saint Germain (FR); Labourie, Christine, F-94800 Villejuif (FR); Doussiere, Pierre, F-91180 Saint Germain les Arpajons (FR)
(74) Mandataire: Bourely, Paul

(56) Documents cités:
- PATENT ABSTRACTS OF JAPAN vol. 12, no. 449 (E-686)(3296) 25 Novembre 1988;& JP-A-63177493
- PATENT ABSTRACTS OF JAPAN vol. 10, no. 121 (E-401)(2178) 7 Mai 198;& JP-A-60254688
- PATENT ABSTRACTS OF JAPAN vol. 10, no. 50 (E-384)(2107) 27 Février 1986;& JP-A-60202976

## Description

La présente invention concerne la réalisation d'un laser semiconducteur du type à ruban enterré. La structure semiconductrice d'un tel laser est internationalement désignée par l'appellation "buried heterojunction" (BH).

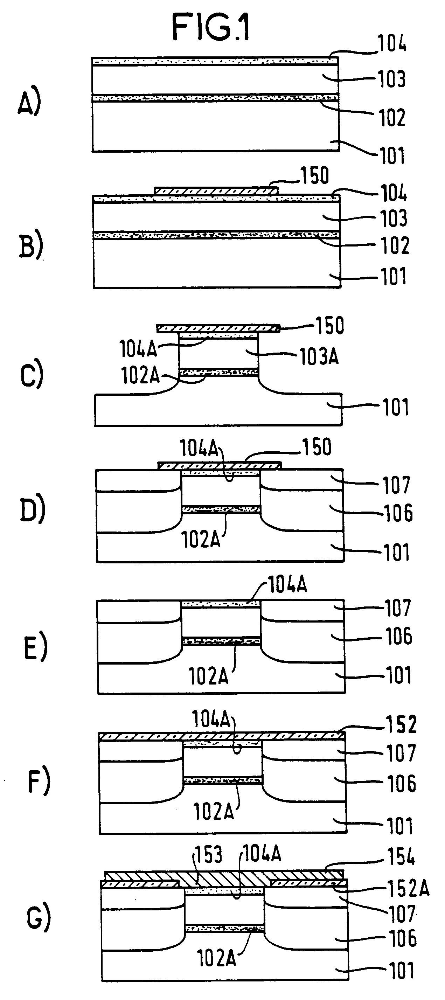

Un procédé connu de fabrication d'un tel laser comporte des étapes dites de croissance de couches au cours desquelles on fait croître l'épaisseur de couches semiconductrices par dépôt épitaxial du matériau de ces couches. Il peut être succinctement décrit de la manière suivante (cf. figure 1).
- Croissance de couches semiconductrices à composition binaire, puis quaternaire, puis binaire sur un substrat. On réalise ainsi une double hétérostructure.
- Croissance d'une couche de contact de composition ternaire ayant une énergie de bande interdite plus faible que la couche de composition binaire précédente.
- Définition d'un ruban laser dans la couche à composition quaternaire par gravure chimique à partir de la face supérieure du substrat en utilisant un masque diélectrique.
- Croissance de deux couches semiconductrices latérales pour entourer et enterrer le ruban laser.
- Prise de contact localisé à travers une fenêtre formée au dessus du ruban laser dans une couche diélectrique préalablement déposée pour cela sur la face supérieure du substrat.

L'étape de croissance de couches latérales fait appel de manière traditionnelle aux méthodes de croissance dites "sélectives".
Celles-ci peuvent présenter divers inconvénients tels qu'un rendement limité. Mais elles permettent la croissance localisée de couches sur le matériau semiconducteur sans dépôt au-dessus du ruban laser. Il faut pour cela que le masque qui a été utilisé pour la définition de ce ruban soit conservé pendant cette étape de croissance. Cette dernière est effectuée à des températures supérieures à 500°C. C'est pourquoi on utilise un masque diélectrique formé par dépôt et gravure d'une couche diélectrique.

Ce procédé connu est par exemple décrit dans un article de HIRAO, M. et al "Long wavelength InGaAsP/InP buried heterostructure laser", J. Opt commun., 1980, 1, pp.10-14.

Il est connu par ailleurs que les lasers semiconducteurs présentent parfois une dégradation de leurs propriétés au cours du temps et que cette dégradation peut résulter d'une pollution en cours de fabrication.

De plus la formation d'une fenêtre de prise de contact pour permettre l'injection localisée de courant dans le ruban laser fait appel à au moins une étape de photolithogravure nécessitant un réalignement délicat.

Par ailleurs un document NTT, PATENT ABSTRACTS OF JAPAN vol.12, no.449 (E-686) (3296) 25 Novembre 1988, abrégé du document JP-A-63 177 493 (NTT) 21 Juillet 1988, décrit la fabrication d'un laser à ruban enterré avec formation des couches latérales par une méthode de croissance non sélective. Cette méthode forme un dépôt non seulement à côté de ce ruban, mais aussi au-dessus de celui-ci en créant une saillie parasite. Cette dernière est éliminée par la suite. Aucune disposition n'est décrite pour localiser le contact électrique au-dessus du ruban laser. Or, l'absence d'une localisation de l'injection du courant dans le ruban laser dégrade de manière importante les performances d'un tel laser.

La présente invention a notamment les buts suivants :
- simplifier un procédé de réalisation d'un laser semiconducteur du type à ruban enterré,
- permettre d'utiliser, dans le cadre de ce procédé, des méthodes de croissance à rendement élevé,
- diminuer les risques de pollution au cours de la formation de la structure semiconductrice de ce composant,
- éviter les difficultés d'un réalignement pour la prise d'un contact sur ce composant,
- et, de manière générale, permettre d'utiliser, dans le cadre de ce procédé, des méthodes susceptibles de présenter des avantages par rapport aux méthodes précédemment employées.

Selon cette invention, après une gravure qui délimite une protubérance en relief sur une couche de confinement, des couches latérales qui doivent entourer cette protubérance sont formées par une méthode de croissance non sélective qui réalise un dépôt non seulement à côté de cette protubérance mais aussi au-dessus de celle-ci en créant une saillie parasite. On forme ensuite une couche de localisation de contact en surface de ces couches latérales et de cette saillie. Puis on utilise cette saillie pour former dans cette couche une fenêtre de contact dont les contours sont définis par ceux de cette saillie. Dans un mode de réalisation cette saillie peut être éliminée par attaque à travers cette fenêtre. Dans tous les cas cette fenêtre permettra ultérieurement de localiser un contact électrique au-dessus de cette protubérance.

Cette protubérance inclut le ruban laser.

La suppression des opérations de formation d'un masque diélectrique simplifie la réalisation du composant. L'absence d'un tel masque évite les perturbations qu'il pourrait apporter au cours de la formation des couches latérales et qui résultent notamment du fait que le matériau diélectrique utilisé peut d'une part se décomposer partiellement d'autre part laisser échapper des éléments polluants qui sont parfois piégés dans des pores de ce matériau. Ceci diminue les risques de dégradation des propriétés du composant. Par ailleurs, les méthodes de croissance non sélectives permettent une élévation du rendement du procédé.

Un autre avantage de l'invention résulte du fait que l'association entre l'élimination de la saillie et la formation de la fenêtre de localisation de courant assure simplement et automatiquement l'alignement de cette fenêtre sur le ruban laser. Cet avantage se traduit par le fait qu'il n'est pas nécessaire d'utiliser des moyens de lithographie pour réaliser cet alignement, ce qui d'une part diminue sensiblement le coût de la fabrication, d'autre part élimine des imprécisions d'alignement qui nuiraient aux performances du composant réalisé.

A l'aide des figures schématiques ci-jointes, on va décrire ci-après comment la présente invention peut être mise en oeuvre, étant entendu que les éléments et dispositions mentionnés et représentés ne le sont qu'à titre non limitatif. Lorsqu'un même élément est représenté sur plusieurs figures il y est désigné par le même signe de référence. Lorsqu'une couche a été désignée par un numéro de référence une fraction de cette couche peut être désignée par le même numéro de référence complété par la lettre A.

Les figures 1A à 1G représentent des vues en coupe d'un substrat semiconducteur après des étapes successives de la réalisation d'un laser par un procédé connu.

Les figures 2 à 11 représentent des vues en coupe d'un substrat semiconducteur après des étapes successives de la réalisation d'un laser par un procédé selon la présente invention.

La figure 12 représente une vue en coupe d'un substrat semiconducteur après une étape de la réalisation d'un laser selon une variante du procédé des figures 2 à 11.

On va d'abord décrire ledit procédé connu. Cette description a pour seul but de permettre d'apercevoir ultérieurement les différences entre ce procédé et la présente invention. Elle sera donc sommaire.

Selon ce procédé, on réalise, sur un substrat non représenté, une couche de confinement inférieure constituée de phosphure d'indium InP dopé n. Sur cette couche, après diverses opérations connues et sans rapport avec la présente invention, on dépose une couche active de composition quaternaire 102, une couche de confinement supérieure 103 constituée d'InP dopé p (Fig. 1A), et une couche de contact 104 de composition ternaire.

On forme, par dépôt et gravure d'une couche diélectrique, un masque diélectrique 150 (Fig. 1B).

Une gravure chimique permet ensuite de définir un ruban laser 102A constitué par la fraction subsistante de la couche active 102 (Fig. 1C) et surmonté par les couches partielles 103A et 104A.

Une méthode de croissance sélective permet ensuite de réaliser la croissance de couches latérales de bloquage 106 et 107, la présence du masque 150 empêchant que le dépôt se fasse aussi au-dessus du ruban 102A (Fig. 1D). Ce masque est ensuite enlevé (Fig. 1E). On dépose ensuite une nouvelle couche diélectrique 152 qui constitue une couche de localisation de contact (Fig. 1F). On forme une fenêtre 153 dans cette couche au-dessus du ruban laser 102A par des procédés de photolithogravure qui sont bien connus mais qui nécessitent de positionner un masque avec une grande précision. L'erreur de position acceptable est en effet de 0,5 micromètre environ.

Le positionnement de ce masque constitue le réalignement précédemment mentionné.

On dépose ensuite une couche métallique 154 qui prend un contact localisé sur la couche de contact fractionnaire 104A.

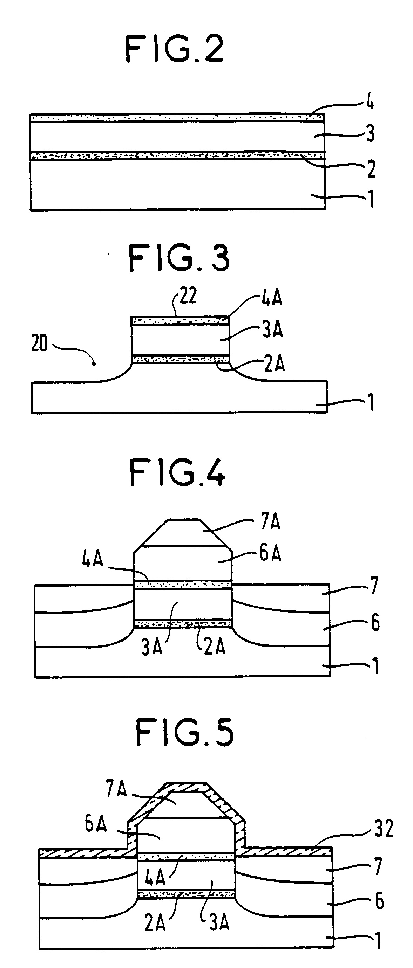

Le procédé selon l'invention comporte diverses étapes qui sont communes, quant aux fonctions indiquées, à ce procédé et au procédé connu qui vient d'être sommairement décrit. Pour faire mieux apparaître par la suite les différences essentielles entre ces deux procédés on va tout d'abord décrire ces étapes communes de manière générale en se référant aux figures 2 à 11.

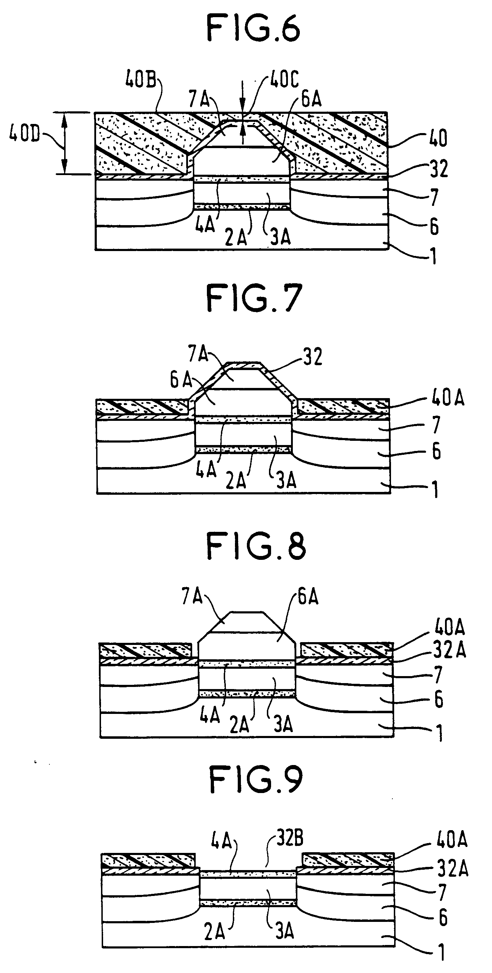

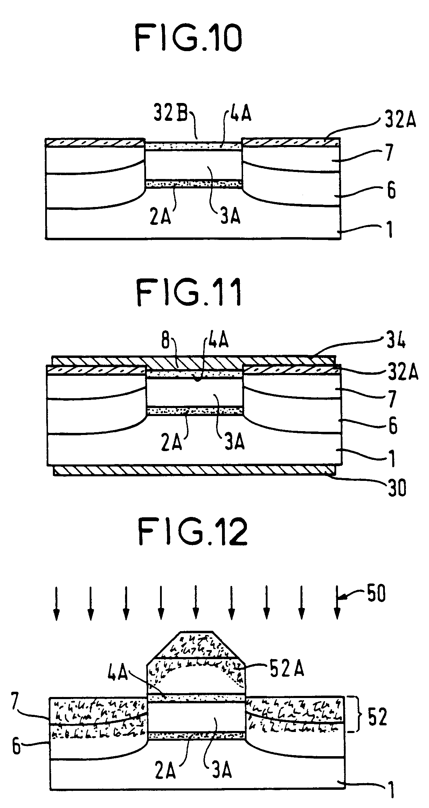

Dans le cadre de ces étapes communes le procédé selon la présente invention comporte d'abord une étape de formation d'une couche de confinement inférieure 1 constituée d'un matériau de base semiconducteur d'un premier type de conductivité. Il comporte ensuite notamment les étapes suivantes (voir figure 2) :
- Croissance d'une couche active 2 constituée d'un matériau actif.
- Croissance d'une couche de confinement supérieure 3 constituée dudit matériau de base présentant le deuxième type de conductivité.
- Croissance d'une couche de contact supérieure 4 constituée d'un matériau de contact.
- Gravure de définition de ruban (voir figure 3). Cette gravure élimine localement au moins les couches active et de confinement supérieure en creusant deux vallées telles que 20 de part et d'autre d'un ruban laser 2A constitué par une portion restante de cette couche active. Ce ruban et les couches qui le surmontent forment un plateau 22 qui subsiste en relief entre ces deux vallées.
- Croissance de couches latérales 6, 7 pour entourer ce ruban laser (voir figure 4).
- Formation d'une couche de localisation de contact 32 en surface desdites couches latérales et de confinement (voir figure 5).
- Formation d'une fenêtre de contact 32B dans cette couche de localisation de contact au-dessus dudit ruban laser 2A (voir figure 9).
- Formation d'électrodes inférieure 30 et supérieure 34 situées respectivement au-dessous et au-dessus desdites couches de confinement inférieure et supérieure (voir figure 11).

Les indices de réfraction, types de conductivité et résistivités électriques des couches de confinement, active et latérales et les positions des bords de la fenêtre de localisation de courant, sont choisis, dans au moins des parties de ces couches, pour réaliser un confinement optique dans ce ruban laser et pour que le passage d'un courant électrique d'alimentation entre ces couches de confinement à partir de ces électrodes soit localisé à travers ce ruban laser et y injecte des porteurs de charges permettant l'amplification d'une lumière que le laser devra émettre.

On va maintenant décrire de manière générale des dispositions propres au procédé selon la présente invention :

L'étape de croissance de couches latérales est réalisée par une méthode de croissance non sélective qui fait croître ledit matériau latéral non seulement dans les vallées telles que 20 pour former les couches latérales 6 et 7 mais aussi sur la couche de contact 4A en formant une saillie parasite 6A, 7A au-dessus du plateau 22 (Fig.4).

L'étape de formation d'une couche de localisation de contact forme ensuite cette couche 32 en surface de ces couches latérales 6, 7 et de cette saillie 6A, 7A (Fig.5) . L'étape suivante est une étape d'élimination de saillie qui élimine cette saillie et la partie de cette couche de localisation de contact située en surface de cette saillie pour former la fenêtre de contact 32B (Fig.10).

De préférence la couche de localisation de contact 32 est formée par dépôt d'un matériau diélectrique, l'électrode supérieure 34 étant déposée sur cette couche.

De préférence encore l'étape d'élimination de saillie comporte elle même les étapes suivantes :
- Dépôt de résine pour former une couche d'une résine protectrice 40 qui couvre les couches latérales 6, 7 et la saillie 6A, 7A et qui présente une surface supérieure 40B régulière de sorte qu'elle a une épaisseur diminuée 40C au-dessus de cette saillie et une épaisseur normale 40D au-dessus de ces couches latérales (fig.6).
- Ablation ménagée de cette résine protectrice pour en éliminer une épaisseur limitée supérieure à ladite épaisseur diminuée et inférieure à ladite épaisseur normale, de manière à découvrir la saillie 6A, 7A, tout en laissant une couche de résine résiduelle 40A sur les couches latérales 6, 7.
- Attaque de la couche de localisation de contact. Cette attaque est réalisée à l'aide d'un milieu d'attaque de diélectrique contre lequel la couche de résine résiduelle 40A constitue une protection, pour qu'une couche de localisation de contact résiduelle 32A subsiste seulement au-dessus des couches latérales 6, 7 (fig.8).
- Attaque de la saillie 6A, 7A. Cette attaque est réalisée à l'aide d'un milieu d'attaque de semiconducteur contre lequel la résine protectice et/ou le matériau diélectrique de la couche 32 constituent une protection. Des moyens de limitation d'attaque sont prévus pour que cette attaque n'élimine pas la couche de confinement supérieure. Ce milieu d'attaque est de préférence choisi pour épargner ledit matériau de contact de sorte que la partie 4A de la couche de contact supérieure qui subsiste au-dessus du ruban laser 2A constitue ces moyens de limitation d'attaque (Fig.9).

On va maintenant décrire plus particulièrement des modalités préférées de réalisation des étapes précédemment décrites.

Sur la couche de confinement inférieure 1 constituée d'InP dopé n on dépose :
- Une couche active 2 épaisse de 100 à 300 nm et constituée de GaInAsP par exemple.
- Une couche de confinement supérieure 3 épaisse de 2 000 nm et constituée d'InP dopé p.
- Et une couche de contact supérieure 4 épaisse de 300 nm et constituée de InGaAs.

La gravure de définition de ruban est réalisée par les techniques connues telles que la gravure dite "sèche", par plasma ou attaque ionique etc...

La croissance des couches latérales 6 et 7, respectivement dopées p et n, permet d'enterrer le ruban laser 2A. Le matériau latéral qui les constitue est le phosphure d'indium InP. La méthode de croissance utilisée ne présente pas de caractère sélectif. Elle peut être en particulier l'EJM (épitaxie par jets moléculaires) ainsi que l'EPVOM (épitaxie en phase vapeur des composés organo-métalliques) utilisée à pression atmosphérique notamment. Cette méthode non sélective donne lieu à la croissance d'un saillie constituée par des bandes 6A et 7A sur le plateau 22. Il faut noter que l'on peut substituer aux couches 6 et 7 une succession de couches comportant une couche d'InP semi-isolante dopée au fer.

La couche de localisation de contact 32 déposée ensuite est mince (fig.5). Son épaisseur est par exemple de 200 nm et elle est constituée de nitrure de silicium Si3N4.

On forme ensuite la couche de résine protectrice 40 (fig.6) qui a par exemple une épaisseur de 4 micromètres. Cette épaisseur est suffisante pour recouvrir la saillie 6A, 7A dont la hauteur est par exemple 2,5 micromètres. Cette couche est formée par une méthode usuelle comportant un dépôt de résine en excès et une centrifugation pour éliminer l'excès de résine déposé.

On effectue ensuite une ablation ménagée de cette résine (fig.7) à l'aide d'un plasma d'oxygène pour découvrir la saillie 6A, 7A.

On attaque ensuite la couche de localisation de contact 32 à l'aide d'un plasma de tétrafluorure de carbone CF4, pour l'éliminer au-dessus de cette saillie et sur les flancs de celle-ci (fig.8). Puis on élimine cette saillie à l'aide d'un milieu d'attaque de semiconducteur qui réalise une attaque chimique et qui est constitué par un mélange liquide contenant quatre parties d'acide chlorhydrique HCl pour une partie d'eau, en volume (fig.9).

Puis on enlève la couche de résine subsistante 40A (fig.10).

Puis on forme l'électrode supérieure 34 par le dépôt successif des couches suivantes :
- 100 nm de titane, 50 nm de platine et 250 nm d'or.

L'électrode inférieure représentée symboliquement en 30 est formée par les techniques classiques.

Dans une variante du procédé qui vient d'être décrit on utilise la saillie 6A, 7A en tant que masque protecteur lors d'une introduction d'impuretés par implantation ou diffusion dans le matériau semiconducteur.

Conformément à la figure 12 une étape d'introduction d'impuretés est donc réalisée entre les étapes de croissance de couches latérales et d'élimination de saillie pour introduire des impuretés dans les couches latérales 6, 7 et la saillie 6A, 7A. Cette introduction est réalisée sur une profondeur ne dépassant pas sensiblement la hauteur de cette saillie de manière qu'après élimination de cette saillie ces impuretés subsistent sélectivement dans ces couches latérales. Ces impuretés ont par exemple pour but d'augmenter la résistivité électrique du matériau latéral pour le rendre semi-isolant.

Ces impuretés sont par exemple des protons implantés par un rayonnement protonique 50. Ils forment une couche semi-isolante 52 dans les couches latérales 6 et 7 dont une partie 52A s'étend dans la saillie 6A, 7A.

Cette couche semi-isolante peut renforcer l'action de la couche de localisation de contact diélectrique 32 qui est ultérieurement déposée. Elle pourrait aussi éventuellement constituer à elle seule la couche de localisation de contact dont la présente invention implique l'utilisation.

## Revendications

1. Procédé de réalisation d'un laser semiconducteur par les opérations suivantes : on effectue une gravure d'une structure semiconductrice pour délimiter une protubérance (2A, 3A, 4A) en relief incluant un ruban laser, puis on forme des couches latérales (6, 7) par une méthode de croissance épitaxiale pour entourer cette protubérance, puis on forme un contact électrique à travers une fenêtre de contact formée dans une couche de localisation de contact au-dessus de cette protubérance, ce procédé étant caractérisé par le fait que ladite méthode de croissance est non sélective de sorte qu'elle réalise un dépôt non seulement à côté de cette protubérance, mais aussi au-dessus de celle-ci en créant une saillie parasite (6A, 7A), ladite couche de localisation de contact (32) étant formée ensuite sur lesdites couches latérales et sur cette saillie, puis on élimine cette saillie avec la partie de la couche de localisation de contact située au dessus de cette saillie pour former ladite fenêtre de contact (32B).

2. Procédé selon la revendication 1, ce procédé comportant une étape de formation d'une couche de confinement inférieure (1) constituée d'un matériau de base semiconducteur d'un premier type de conductivité,
- ce procédé comportant ensuite d'autre étapes dont certaines sont des étapes de croissance de couches pour effectuer des dépôts épitaxiaux de couches semiconductrices, ces autres étapes incluant les étapes suivantes ;
- croissance d'une couche active (2) constituée d'un matériau actif,
- croissance d'une couche de confinement supérieure (3) constituée dudit matériau de base présentant le deuxième type de conductivité,
- gravure de définition de ruban, cette gravure éliminant localement au moins lesdites couches active et de confinement supérieure en creusant deux vallées (20) de part et d'autre d'un ruban laser (2A) constitué par une portion restante de cette couche active, ce ruban et les couches qui le surmontent formant ladite protubérance (2A, 3A,4A) dont la surface supérieure constitue un plateau (22) qui s'étend entre ces deux vallées,
- croissance de couches latérales (6, 7) constituées d'un matériau latéral pour entourer ce ruban laser, les indices de réfraction, types de conductivité et résistivités électriques de ces couches de confinement, active et latérales, étant choisis, dans au moins des parties de ces couches, pour réaliser un confinement optique dans ce ruban laser et pour qu'un courant électrique d'alimentation passant entre ces couches de confinement passe préférentiellement à travers ce ruban laser et y permette l'amplification d'une lumière,
- formation d'une couche de localisation de contact (32) en surface desdites couches latérales et de confinement,
- formation d'une fenêtre de contact (32B) dans cette couche de localisation de contact au-dessus dudit ruban laser (2A),
- et formation d'électrodes inférieure (30) et supérieure (34) situées respectivement au-dessous et au-dessus desdites couches de confinement inférieure et supérieure pour permettre de faire passer ce courant d'alimentation, la zone de contact de cette électrode supérieure étant définie par ladite fenêtre de contact pour que ce courant d'alimentation soit localisé à travers ce ruban,
- ce procédé étant caractérisé par le fait que ladite étape de croissance de couches latérales est réalisée par une méthode de croissance non sélective qui fait croître ledit matériau latéral non seulement dans lesdites vallées pour former lesdites couches latérales (6, 7), mais aussi sur ladite couche de confinement supérieure (3) en formant une saillie parasite (6A, 7A) au-dessus dudit plateau (22),
- ladite étape de formation d'une couche de localisation de contact formant ensuite cette couche (32) en surface de ces couches latérales (6, 7) et de cette saillie (6A, 7A),
- ce procédé comportant ensuite une étape d'élimination de saillie qui élimine cette saillie et la partie de cette couche de localisation de contact située en surface de cette saillie pour former ladite fenêtre de contact (32B).

3. Procédé selon la revendication 2, caractérisé par le fait que ladite couche de localisation de contact (32) est formée par dépôt d'un matériau diélectrique, ladite électrode supérieure (34) étant déposée sur cette couche.

4. Procédé selon la revendication 2, caractérisé par le fait que ladite étape d'élimination de saillie comporte elle même les étapes suivantes :
- dépôt de résine pour former une couche d'une résine protectrice (40) qui couvre lesdites couches latérales (6, 7) et ladite saillie (6A, 7A) et qui présente une surface supérieure (40B) régulière de sorte qu'elle a une épaisseur diminuée (40C) au-dessus de cette saillie et une épaisseur normale (40D) au-dessus de ces couches latérales,
- ablation ménagée de cette résine protectrice pour en éliminer une épaisseur limitée supérieure à ladite épaisseur diminuée et inférieure à ladite épaisseur normale, de manière à découvrir ladite saillie, tout en laissant une couche de résine résiduelle (40A) sur lesdites couches latérales (6, 7),
- attaque de ladite couche de localisation de contact (32), cette attaque étant réalisée à l'aide d'un milieu d'attaque de couche de localisation contre lequel ladite couche de résine résiduelle (40A) constitue une protection, pour que la couche de localisation de contact subsiste seulement au-dessus desdites couches latérales (6, 7) sous la forme d'une couche de localisation de contact résiduelle (32A),
- et attaque de ladite saillie, cette attaque étant réalisée à l'aide d'un milieu d'attaque de semiconducteur contre lequel ladite résine protectice et/ou ladite couche de localisation de contact constituent une protection, des moyens de limitation d'attaque étant prévus pour que cette attaque n'élimine pas ladite couche de confinement supérieure.

5. Procédé selon la revendication 4, caractérisé par le fait qu'il comporte, entre lesdites étapes de croissance de couche de confinement supérieure et de gravure de définition de ruban, une étape de croissance d'une couche de contact supérieure constituée d'un matériau de contact de composition intrinséque différente de celle dudit matériau de base, ledit milieu d'attaque de semiconducteur étant choisi pour épargner ce matériau de contact de sorte que la partie (4A) de la couche de contact supérieure qui subsiste au dessus dudit ruban laser constitue lesdits moyens de limitation d'attaque.

6. Procédé selon la revendication 5, lesdits matériaux de base et latéral ayant une composition intrinséque binaire, lesdits matériaux actif et de contact ayant une composition intrinsèques ternaire et/ou quaternaire.

7. Procédé selon la revendication 6, lesdits matériaux de base et latéral étant le phosphure d'indium ou l'arseniure de gallium, lesdits matériaux actif et de contact comportant en outre du gallium, de l'aluminium et/ou de l'arsenic.

8. Procédé selon la revendication 1, caractérisé par le fait qu'on introduit des impuretés dans les couches latérales (6, 7) et la saillie parasite (6A, 7A) sur une profondeur ne dépassant pas sensiblement la hauteur de cette saillie de manière qu'après élimination de cette saillie ces impuretés subsistent sélectivement dans ces couches latérales.

9. Procédé selon la revendication 8, caractérisé par le fait que lesdites impuretés sont choisies pour augmenter la résistivité électrique dans lesdites couches latérales (6, 7).

## Patentansprüche

1. Verfahren zur Herstellung eines Halbleiterlasers mit Hilfe folgender Operationen: man ätzt eine Halbleiterstruktur, um einen reliefartigen Vorsprung (2A, 3A, 4A) zu begrenzen, der ein Laserband einschließt, dann bildet man seitliche Schichten (6, 7) mittels einer epitaxialen Wachstumsmethode, um diesen Vorsprung einzuschließen, dann bildet man einen elektrischen Kontakt durch ein in einer Kontaktlokalisationsschicht gebildetes Fenster oberhalb dieses Vorsprungs, dadurch gekennzeichnet, daß die Wachstumsmethode nicht selektiv ist, so daß eine Schicht nicht nur neben diesem Vorsprung abgeschieden wird, sondern auch oberhalb des Vorsprungs, indem ein störender Überstand (6A, 7A) erzeugt wird, wobei die Kontaktlokalisationsschicht (32) dann auf den seitlichen Schichten und diesem Überstand ausgebildet wird, worauf der Überstand mit dem Teil der Kontaktlokalisationsschicht entfernt wird, der sich oberhalb dieses Überstands befindet, um das Kontaktfenster (32B) zu bilden.

2. Verfahren nach Anspruch 1, das einen Verfahrensschritt enthält, in dem eine untere Einschließungsschicht (1) bestehend aus einem halbleitenden Basismaterial eines ersten Leitfähigkeitstyps gebildet wird,
- wobei dieses Verfahren dann weitere Schritte enthält, von denen einige zum Wachstum von Schichten führen, um epitaxial Halbleiterschichten aufzubringen, wobei diese anderen Verfahrensschritte folgende Schritte enthalten:
- Aufwachsen einer aktiven Schicht (2) bestehend aus einem aktiven Material,
- Aufwachsen einer oberen Einschließungsschicht (3) bestehend aus dem Basismaterial, das vom zweiten Leitfähigkeitstyp ist,
- Ätzen der Bandumgrenzung, bei der mindestens die aktive Schicht und die obere Einschließungsschicht entfernt wird und zwei Täler (20) zu beiden Seiten eines von einem verbleibenden Teil dieser aktiven Schicht gebildeten Laserbands (2A) gebildet werden, wobei dieses Band und die darüberliegenden Schichten den Vorsprung (2A, 3A, 4A) bilden, dessen obere Oberfläche ein sich zwischen den beiden Tälern erstreckendes Plateau (22) bildet,
- Aufwachsen von seitlichen Schichten (6, 7) aus einem seitlichen Material, um das Laserband zu umgeben, wobei die Brechungsindices, die Leitfähigkeitstypen und elektrischen spezifischen Widerstände dieser Einschließungsschicht, der aktiven Schicht und der seitlichen Schichten zumindest in Teilen dieser Schichten so gewählt sind, daß sich eine optische Einschließung im Laserband ergibt und ein elektrischer Speisestrom, der zwischen den Einschließungsschichten verläuft, bevorzugt durch das Laserband fließt und dort eine Lichtverstärkung erlaubt,
- Ausbildung einer Kontaktlokalisationsschicht (32) an der Oberfläche der seitlichen Schichten und der Einschließungsschicht,
- Ausbildung eines Kontaktfensters (32B) in dieser Kontaktlokalisationsschicht oberhalb des Laserbands (2A),
- Ausbildung einer unteren Elektrode (30) und einer oberen Elektrode (34) unterhalb bzw. oberhalb der unteren bzw. oberen Einschließungsschicht, um den Speisestrom fließen zu lassen, wobei die Kontaktzone der oberen Elektrode durch das Kontaktfenster so definiert ist, daß der Speisestrom durch das Band hindurch konzentriert ist,
- dadurch gekennzeichnet, daß der Verfahrensschritt des Wachstums der seitlichen Schichten mit Hilfe einer nicht selektiven Wachstumsmethode erfolgt, die das seitliche Material nicht nur in den Tälern zur Bildung der seitlichen Schichten (6, 7), sondern auch auf der oberen Einschließungsschicht (3) wachsen läßt, indem ein störender Überstand (6A, 7A) oberhalb dieses Plateaus (22) gebildet wird,
- wobei der Verfahrensschritt der Bildung einer örtlich begrenzten Kontaktlokalisationsschicht dann zu der Schicht (32) an der Oberfläche der seitlichen Schichten (6, 7) und des Überstands (6A, 7A) führt,
- wobei das Verfahren dann einen Schritt enthält, bei dem der Überstand entfernt wird und sowohl dieser Überstand als auch der Teil der Kontaktlokalisationsschicht entfernt wird, der sich an der Oberfläche dieses Überstands befindet, um das Kontaktfenster (32B) zu bilden.

3. Verfahren nach Anspruch 2, dadurch gekennzeichnet, daß die Kontaktlokalisationsschicht (32) durch Aufbringen eines dielektrischen Materials gebildet wird und daß die obere Elektrode (34) auf dieser Schicht abgeschieden wird.

4. Verfahren nach Anspruch 2, dadurch gekennzeichnet, daß der Verfahrensschritt der Entfernung des Überstands seinerseits die folgenden Verfahrensschritte aufweist:
- Aufbringen einer Schutzharzschicht (40), die die seitlichen Schichten (6, 7) und den Überstand (6A, 7A) bedeckt und eine regelmäßige Oberseite (40B) derart bildet, daß sie eine verringerte Dicke (40C) oberhalb dieses Überstands und eine normale Dicke (40D) oberhalb der seitlichen Schichten besitzt,
- Abtragen dieser Schutzharzschicht in einer begrenzten Dicke, die größer als die verringerte Dicke und kleiner als die normale Dicke ist, so daß der Überstand freigelegt wird, während eine Restharzschicht (40A) über den seitlichen Schichten (6, 7) verbleibt,
- Abätzen der Kontaktlokalisationsschicht (32) mit Hilfe eines Ätzmilieus, gegen das die verbleibende Harzschicht einen Schutz bildet, so daß die Kontaktlokalisationsschicht nur oberhalb der seitlichen Schichten (6,7) in Form einer restlichen Kontaktlokalisationsschicht (32A) verbleibt,
- und Abätzen des Überstands mit Hilfe eines Halbleiter-Ätzmilieus, gegen das das Schutzharz und/oder die Kontaktlokalisationsschicht einen Schutz bilden, wobei Mittel zur Begrenzung des Ätzens vorgesehen sind, so daß dieser Ätzvorgang die obere Einschließungsschicht nicht entfernt.

5. Verfahren nach Anspruch 4, dadurch gekennzeichnet, daß zwischen dem Verfahrensschritt des Aufwachsen der oberen Einschließungsschicht und dem Verfahrensschritt des Abätzens der Bandumgrenzung ein Verfahrensschritt eingefügt ist, in dem eine obere Kontaktlokalisationsschicht bestehend aus einem Kontaktmaterial einer intrinsisch anderen Zusammensetzung als die des Basismaterials aufwächst, wobei das Halbleiter-Ätzmilieu so ausgewählt ist, daß es dieses Kontaktmaterial nicht angreift, so daß der Bereich (4A) der oberen Kontaktlokalisationsschicht, der oberhalb des Laserbands verbleibt, die Mittel zur Begrenzung des Ätzens darstellt.

6. Verfahren nach Anspruch 5, wobei das Basismaterial und das seitliche Material einen intrinsisch binären Aufbau besitzen, während das aktive Material und das Kontaktmaterial einen intrinsisch ternären und/oder quaternären Aufbau besitzen.

7. Verfahren nach Anspruch 6, wobei das Basismaterial und das seitliche Material von Indiumphosphid oder Galliumarsenid gebildet werden, während das aktive Material und das Kontaktmaterial außerdem Gallium, Aluminium und/oder Arsen enthält.

8. Verfahren nach Anspruch 1, dadurch gekennzeichnet, daß man Verunreinigungen in die seitlichen Schichten (6, 7) und den störenden Überstand (6A, 7A) über eine Tiefe einbringt, die nicht wesentlich die Höhe dieses Überstands überschreitet, so daß nach Entfernung dieses Überstands diese Verunreinigungen selektiv nur in den seitlichen Schichten verbleiben.

9. Verfahren nach Anspruch 8, dadurch gekennzeichnet, daß die Verunreinigungen so gewählt sind, daß sie den spezifischen elektrischen Widerstand in den seitlichen Schichten (6, 7) erhöhen.

## Claims

1. Method of manufacturing a semiconductor laser in which a semiconductor structure is etched to delimit a protuberance (2A, 3A, 4A) including a laser stripe after which lateral layers (6, 7) are formed by an epitaxial growth method to surround said protuberance after which an electric contact is formed through a contact window formed in a contact localising layer on top of said protuberance, characterised in that said growth method is a non-selective growth method which forms a deposit not only at the sides of said protuberance but also on top of said protuberance to create a parasitic projection (6A, 7A), after which said contact localising layer (32) is formed on said lateral layers and on said projection, after which said projection is removed with the part of the contact localising layer situated on top of said projection to form said contact window (32B).

2. Method according to claim 1 comprising a step of forming a lower confinement layer (1) consisting of a semiconductor base material with a first type of conductivity and further steps including epitaxial layer growing steps to deposit semiconductor layers, said other steps including:
- growing an active layer (2) of an active material,
- growing an upper confinement layer (3) of said base material having the second type of conductivity,
- etching to define the boundaries of said laser stripe by locally eliminating at least said active layer and said upper confinement layer by etching two valleys (20) one on each side of a laser stripe (2A) constituted by a remaining portion of said active layer, said stripe and the layers on top of it forming said protuberance (2A, 3A, 4A) whose upper surface constitutes a mesa (22) which extends between said two valleys,
- growing lateral layers (6, 7) surrounding said laser stripe, the refractive indices, types of electrical conductivity and resistivity of said active and lateral confinement layers being selected in parts at least of said layers to establish optical confinement in said laser stripe and so that an energising electrical current flowing between said confinement layers preferably passes through said laser stripe and enables light amplification to take place therein,
- forming a contact localising layer (32) on the surface of said lateral and confinement layers,
- forming a contact window (32B) in said contact localising layer on top of said laser stripe (2A), and
- forming lower and upper energising current electrodes (30, 34) respectively on the bottom and on the top of said lower and upper confinement layers, the contact area of said upper electrode being defined by said contact window so that said energisation current is localised through said laser stripe, which method is characterised in that said lateral layer growth step uses a non-selective growth method which grows said lateral layer material not only in said valleys for forming said lateral layers (6, 7) but also on said upper confinement layer (3) to form a parasitic projection (6A, 7A) above said mesa (22), said contact localising layer formation step then forming said layer (32) on the surface of said lateral layers (6, 7) and said projection (6A, 7A), the method then comprising a projection removal step which eliminates the projection and the part of said contact localising layer on the surface of said projection to form said contact window (32B).

3. Method according to claim 2 characterised in that said contact localising layer (32) is formed by depositing a dielectric material, said upper electrode (34) being deposited on said contact localising layer.

4. Method according to claim 2 characterised in that said projection removal step comprises the following steps:
- depositing resin to form a protective resin layer (40) covering said lateral layers (6, 7) and said projection (6A, 7A) and which has a regular upper surface (40B) whereby it has a reduced thickness (40C) above said projection and a normal thickness (40D) above said lateral layers,
- carefully removing said protecting resin to eliminate a restricted thickness thereof greater than said reduced thickness and less than said normal thickness so as to uncover said projection and to leave a residual resin layer (40A) on said lateral layers (6, 7),
- attacking said contact localising layer (32) using a localising layer attacking medium against which said residual resin layer (40A) provides protection so that the contact localising layer remains only on top of said lateral layers (6, 7) in the form of a residual contact localising layer (32A), and
- attacking said projection using a semiconductor attacking medium against which said protective resin and/or said contact localising layer provide(s) protection, attack limiting means being provided so that such attack does not remove said upper confinement layer.

5. Method according to claim 4 characterised in that it comprises between said upper confinement layer growth step and said laser stripe definition etching step, an upper contact layer growth step depositing a contact material having a different intrinsic composition than said base material, said semiconductor attacking medium being selected so that it does not attack said contact material so that the part (4A) of the upper contact layer which remains on top of said laser stripe constitutes said attack limiting means.

6. Method according to claim 5 wherein said base material and said lateral layer material have a binary intrinsic composition and said active material and said contact material have a ternary and/or quaternary intrinsic composition.

7. Method according to claim 6 wherein said base material and said lateral layer material are indium phosphide or gallium arsenide and said active material and said contact material are gallium, aluminium and/or arsenic.

8. Method according to claim 1 characterised in that impurities are introduced into the lateral layers (6, 7) and the parasitic projection (6A, 7A) to a depth not substantially exceeding the height of said projection so that after removal of said projection said impurities remain selectively in said lateral layers.

9. Method according to claim 8 characterised in that said impurities are chosen to increase the electrical resistivity in said lateral layers (6, 7).
